# EUROPEAN PATENT APPLICATION

(11) **EP 3 733 923 A1**
(43) Date of publication of application: **04.11.2020**
(21) Application number: 20167725.9
(22) Date of filing: 02.04.2020
(51) Int. Cl.: C23C 4/00, C23C 8/10, C23C 14/00, C23C 28/00, F01D 5/00, F01D 5/28, F01D 9/00, F01D 25/00

(54) **A METHOD OF APPLYING A CERAMIC COATING ONTO A METALLIC ARTICLE**

(30) Priority: 01.05.2019 GB 201906099
(71) Applicant: Rolls-Royce plc, London N1 9FX (GB)
(72) Inventor: Delfan-Azari, Mehrzad, Derby, Derbyshire DE24 8BJ (GB)
(74) Representative: Rolls-Royce plc

(57) **Abstract**

A method (100) of applying a ceramic coating onto a metallic article (42, 62, 62A). The method comprising the sequential steps of: a) producing a compressive residual stress in the surface of the metallic article by water jet peening the metallic article; b) applying a bond coating to the surface of the metallic article by the sequential steps of: i) applying a layer of platinum-group metal onto the metal article, ii) heat treating the metallic article to diffuse the platinum-group metal into the metallic article to produce a platinum-group metal enriched outer layer on the metallic article, and iii) heating the metallic article in an oxygen containing atmosphere to form a layer of alpha alumina on the surface of the platinum-group metal enriched outer layer of the metallic article; and c) depositing the ceramic coating onto the layer of alpha alumina on the metallic article. The metal article may be a turbine blade (42), a turbine vane segment (62) or a turbine vane (62A) of a gas turbine engine (10).

## Description

### Field of the disclosure

The present disclosure relates to a method of applying a ceramic coating onto a metallic article and in particular relates to a method of applying a ceramic coating onto a superalloy article.

### Background

Internal combustion engines for example continuous combustion engine e.g. gas turbine engines, reciprocating engines e.g. diesel engines and petrol engines and rotary engines e.g. Wankel engines and turbomachines have thermal barrier coated metallic articles, e.g. ceramic coated metallic articles. Gas turbine engines have ceramic coated turbine blades, turbine vanes, combustion chamber tiles, combustion chamber heat shields and other articles or components. Turbomachines, e.g. steam turbines, may have ceramic coated turbine blades, turbine vanes and other articles or components. Diesel engines and petrol engines may have ceramic coated pistons, cylinders and other articles or components. These articles are generally metallic components, for example nickel based superalloys, cobalt based superalloys or iron based superalloys. These metallic articles may comprise a single crystal, for example a single crystal nickel based superalloy.

The ceramic coating is generally an yttria stabilised zirconia coating, but may have alternative stabilising oxides and/or one or more additional oxides to reduce the conductivity of the ceramic coating. The ceramic coating may be deposited by physical vapour deposition, e.g. electron beam physical vapour deposition, to produce a columnar grain ceramic structure in which the columnar grains extend perpendicularly relative to the surface of the metal article. Alternatively, the ceramic coating may be deposited by thermal spraying, e.g. plasma spraying, flame spraying, high velocity oxy-fuel (HVOF) spraying, to produce a lamellae microstructure consisting of flattened splats, a splat morphology, of ceramic. The columnar grain ceramic structure is more porous and less dense than the lamellae microstructure. Columnar grain microstructure bonds to an oxide layer on the metallic bond coating whereas the lamellae microstructure bonds to a rough surface on the metallic bond coating.

The ceramic coated metal articles are provided with a metallic bond coating on the metal article and a ceramic coating on the metallic bond coating. The metallic bond coating is provided to enhance the adherence of the ceramic coating onto the metal article and to provide corrosion resistance and/or oxidation resistance to the metal article. A ceramic coated metal article is manufactured by depositing a bond coating onto the surface of the metal and then depositing a ceramic coating onto the bond coating. The metallic bond coating may be an aluminium containing. The metallic bond coating may be an overlay coating for example a MCrAlY coating, a MCrAl coating or a MAl coating. The metallic bond coating may be a diffusion aluminide coating for example a simple aluminide coating, a platinum aluminide coating, a chromium aluminide coating, a platinum chromium aluminide coating, an aluminide silicide coating, a platinum aluminide silicide coating, a chromium aluminide silicide coating or a platinum chromium aluminide silicide coating. The metallic bond coating may be a platinum group metal containing coating.

One, or more, portions of the metallic articles are often provided with a plurality of apertures to provide a film of coolant onto the surface of the metallic articles. These apertures are commonly produced by electro-discharge machining, EDM, or by laser machining. A problem with producing the apertures by electro-discharge, or laser, machining is that a recast layer is produced in the metallic article, due to the heating effect of the machining process, around each of the apertures in the metallic article. The recast layer, it is believed, comprises alumina and the alumina inhibits the subsequent diffusion of platinum group metal into the metallic article.

In the process of applying a ceramic coating to the metallic article the surface of the metallic article is blasted with alumina grit, alumina particles, to prepare the surface of the metallic article for the bond coating. A problem with using the alumina grit is that some of the alumina grit becomes trapped in surface irregularities produced during the manufacture, e.g. casting or investment casting, of the metallic article. Again the alumina grit inhibits the subsequent diffusion of platinum group metal into the metallic article.

The bond coating, e.g. the platinum group metal, dictates the operating life of the ceramic coated metallic article.

Columnar grain ceramic coatings are attached to the underlying bond coating by a thin layer of thermally grown metal oxide, e.g. alumina, layer which forms on the surface of the bond coating and a bond is formed between the metal oxide, alumina, and the columnar grain ceramic coating at the interface between the metal oxide, alumina, layer and the columnar grain ceramic coating. The durability, e.g. spalling and delamination, of the columnar grain ceramic coating is dictated by the steady growth and stable formation of the thin metal oxide, alumina, layer. Exposure of the ceramic coated metallic article to temperatures above 1000°C in an oxidising environment causes the alumina to change to alpha alumina which involves a volume change leading to spallation and/or delamination of the ceramic coating at the interface between the alumina layer and the ceramic coating.

The alumina layer also dictates the operating life of the ceramic coated metallic article.

The metallic article underneath the ceramic coating also dictates the operating life of the ceramic coated metallic article. The metallic article may fail due to thermal fatigue.

The present disclosure seeks to provide a method of applying a ceramic coating to metal article which reduces, or overcomes, the above mentioned problems.

### Summary

The present disclosure provides a method of applying a ceramic coating onto a metallic article as set out in the appended claims.

According to a first aspect there is provided a method of applying a ceramic coating onto a metallic article, the method comprising the sequential steps of:
a) producing the compressive residual stress in the surface of the metallic article by water jet peening the metallic article;
b) applying a bond coating to the surface of the metallic article by the sequential steps of:
   i) applying a layer of platinum-group metal onto the metal article,
   ii) heat treating the metallic article to diffuse the platinum-group metal into the metallic article to produce a platinum-group metal enriched outer layer on the metallic article,
   iii) heating the metallic article in an oxygen containing atmosphere to form a layer of alpha alumina on the surface of the platinum-group metal enriched outer layer of the metallic article; and
c) depositing a ceramic coating on the bond coating on the metallic article.

The water jet peening of the metallic article produces a compressive residual stress in the surface of the metallic article and may remove alumina from apertures in the metallic article and/or may remove alumina grit particles from the surface of the metallic article. The water jet peening is arranged such that water droplets impact upon the metallic article.

There may be an extra step after heat treating the metallic article to diffuse the platinum-group metal into the metallic article to produce a platinum-group metal enriched outer layer on the metallic article and before forming the layer of alpha alumina on the surface of the platinum-group metal enriched outer layer of the metallic article of grit blasting or water jet blasting the surface of the platinum-group metal enriched outer layer of the metallic article.

The layer of platinum-group metal may be applied to the metallic article without alumina grit blasting the metallic article before applying the layer of platinum-group metal so that no alumina grit is left trapped on the surface of the metal article.

There may be an extra step after depositing an aluminide bond coating onto the metallic article or depositing an overlay bond coating onto the metallic article of grit blasting or water jet blasting the surface of the bond coating on the metallic article.

There may be a step of chemical cleaning before step a). The chemical cleaning may comprises using a solvent and a detergent. There may be a step of removing organic material from the metallic article after chemical cleaning and before step a). The removing of the organic material may comprises heating the metallic article to burn the organic material.

Step a) may comprise water jet peening the metallic article by directing water at the metallic article from a nozzle at a pressure of 275 to 296 MPa (40,000 to 43,000 psi), arranging the nozzle at a stand-off distance from the metallic article of 20 to 30 mm and traversing the nozzle over the metallic article at a speed of 2.5 to 3.8 mm per second. Step a) may comprise water jet peening the metallic article by directing water at the metallic article from a nozzle at a pressure of 275 to 290 MPa (40,000 to 42,000 psi), arranging the nozzle at a stand-off distance from the metallic article of 22 to 28 mm and traversing the nozzle over the metallic article at a speed of 2.7 to 3.5 mm per second. Step a) may comprise water jet peening the metallic article by directing water at the metallic article from a nozzle at a pressure of 284.7 MPa (41,300 psi), arranging the nozzle at a stand-off distance from the metallic article of 25 mm and traversing the nozzle over the metallic article at a speed of 2.9 mm per second. Step a) may comprise water jet peening the metallic article by directing water at the metallic article from a nozzle at a pressure of 284.7 MPa (41,300 psi), arranging the nozzle at a stand-off distance from the metallic article of 25 mm and traversing the nozzle over the metallic article at a speed of 3.3 mm per second.

There may be a step of ultrasonic cleaning after step a) and before step b). The ultrasonic cleaning step may comprise immersing the metallic article in a weak acid and agitating the weak acid using ultrasonic signals to generate cavitation in the weak acid. The weak acid may comprise citric acid.

Step b) may comprise electroplating. Step b) may comprise applying a layer of platinum. Step ii) may comprise heating at a temperature of 1100 °C to 1200 °C. Step iii) may comprise heating at a temperature of 1150 °C to 1200 °C.

Step c) may comprise depositing the ceramic coating by physical vapour deposition to produce a columnar grain ceramic coating. Step c) may comprise depositing the ceramic coating by electron beam physical vapour deposition to produce a columnar grain ceramic coating.

The metallic article may be a superalloy article. The superalloy article may be a nickel based superalloy, a cobalt based superalloy or an iron based superalloy. The metallic article may be a single crystal metallic article.

The ceramic coating may comprise yttria stabilised zirconia. The ceramic coating may comprise zirconia stabilised with ceria, ytterbia or india. The ceramic coating may comprise zirconia stabilised with yttria and erbia. The ceramic coating may comprise zirconia stabilised with yttria, erbia and gadolinia. The ceramic coating may comprise zirconia stabilised with yttria and gadolinia.

The metallic article may be a turbine blade comprising a root, a shank, a platform and an aerofoil. The metallic article may be a turbine vane comprising a first platform, a second platform and an aerofoil extending between and secured to the first and second platforms. The metallic article may be a turbine vane segment comprising a first platform, a second platform and a plurality of aerofoils, each aerofoil extending between and secured to the first and second platforms. The metallic article may be a combustion chamber tile, a combustion chamber heat shield or a combustion chamber segment or other gas turbine engine or turbomachine component.

The nozzle may be rotated at 1000 rpm +/- 100 rpm. The nozzle may comprise an orifice having a diameter of 0.58 mm. The passes of the water jet may be arranged to overlap by 50%. The nozzle may be arranged to direct the water jet at any cooling apertures in the metallic article to remove ceramic coating therefrom. The nozzle may be arranged on a 6 axis robot.

Step a) may comprise directing water droplets onto the metallic article to produce an impact pressure of equal to more than 10 GPa and equal to or less than 14 GPa. Step a) may comprise directing water droplets onto the metallic article to produce an impact pressure of equal to more than 11 GPa and equal to or less than 13.5 GPa. Step a) may comprise directing water droplets onto the metallic article to produce an impact pressure of equal to 11.3 GPa. Step a) may comprise directing water droplets onto the metallic article to produce an impact pressure of equal to 13.0 GPa.

Step a) may comprise producing a compressive residual stress to a depth of 60 µm from the surface of the metallic article of equal to or more than 1000 MPa and equal to or less than 1200 MPa. Step a) may comprise producing a compressive residual stress of 1024 MPa to a depth of 60 µm from the surface of the metallic article. Step a) may comprise producing a compressive residual stress of 1170 MPa to a depth of 60 µm from the surface of the metallic article.

The method may comprise an additional step of providing an age heat treatment after step c), the age heat treatment comprising heating to and maintaining at a temperature of 870 °C for sixteen hours.

The method may comprise a further step of providing a stress relieving heat treatment after step c), the stress relieving heat treatment comprising heating to and maintaining at a temperature of 1100 °C for one hour. The method may comprise an additional step of providing an age heat treatment after the stress relieving heat treatment, the age heat treatment comprising heating to and maintaining at a temperature of 870 °C for sixteen hours.

According to a second aspect there is provided a method of applying a ceramic coating onto a metallic article, the method comprising the sequential steps of:
a) water jet peening the metallic article at a pressure of 275 to 296 MPa to produce a compressive residual stress in the surface of the metallic article,
b) applying a layer of platinum-group metal onto the metal article,
c) heat treating the metallic article at a temperature of 1100 °C to 1200 °C to diffuse the platinum-group metal into the metallic article to produce a platinum-group metal enriched outer layer on the metallic article,
d) heating the metallic article at a temperature of 1150 °C to 1200 °C in an oxygen containing atmosphere to form a layer of alpha alumina on the surface of the platinum-group metal enriched outer layer of the metallic article, and
e) depositing a ceramic coating by physical vapour deposition onto the layer of alpha alumina on the metallic article.

According to a third aspect there is provided a method of applying a ceramic coating onto a metallic article, the method comprising the sequential steps of:
a) water jet peening the metallic article to produce a compressive residual stress in the surface of the metallic article, the water jet peening comprising directing water droplets with a diameter of 17 to 18 µm with a velocity of 650 ms⁻¹ to 690 ms⁻¹ onto the metallic article,
b) applying a layer of platinum-group metal onto the metal article,
c) heat treating the metallic article at a temperature of 1100 °C to 1200 °C to diffuse the platinum-group metal into the metallic article to produce a platinum-group metal enriched outer layer on the metallic article,
d) heating the metallic article at a temperature of 1150 °C to 1200 °C in an oxygen containing atmosphere to form a layer of alpha alumina on the surface of the platinum-group metal enriched outer layer of the metallic article, and
e) depositing a ceramic coating by physical vapour deposition onto the layer of alpha alumina on the metallic article.

The method may comprise directing water droplets with a diameter of 17.4 onto the metallic article. The method may comprise directing water droplets with a velocity of 660 ms⁻¹ to 680 ms⁻¹ onto the metallic article. The method may comprise directing water droplets with a velocity of 667 ms⁻¹ onto the metallic article. The method comprising directing water droplets onto the metallic article to produce an impact pressure of equal to more than 10 GPa and equal to or less than 14 GPa.

According to a fourth aspect there is provided a method of applying a ceramic coating onto a metallic article, the method comprising the sequential steps of:
a) water jet peening the metallic article at a pressure of 275 to 296 MPa to produce a compressive residual stress in the surface of the metallic article,
b) applying a bond coating to the surface of the metallic article,
c) heating the metallic article in an oxygen containing atmosphere to form a layer of alumina on the surface of the bond coating, and
e) depositing a ceramic coating on the layer of alumina on the bond coating on the metallic article.

As noted elsewhere herein, the present disclosure may relate to a gas turbine engine. Such a gas turbine engine may comprise an engine core comprising a turbine, a combustor, a compressor, and a core shaft connecting the turbine to the compressor. Such a gas turbine engine may comprise a fan (having fan blades) located upstream of the engine core.

Arrangements of the present disclosure may be particularly, although not exclusively, beneficial for fans that are driven via a gearbox. Accordingly, the gas turbine engine may comprise a gearbox that receives an input from the core shaft and outputs drive to the fan so as to drive the fan at a lower rotational speed than the core shaft. The input to the gearbox may be directly from the core shaft, or indirectly from the core shaft, for example via a spur shaft and/or gear. The core shaft may rigidly connect the turbine and the compressor, such that the turbine and compressor rotate at the same speed (with the fan rotating at a lower speed).

The gas turbine engine may have any suitable general architecture. For example, the gas turbine engine may have any desired number of shafts that connect turbines and compressors, for example one, two or three shafts. Purely by way of example, the turbine connected to the core shaft may be a first turbine, the compressor connected to the core shaft may be a first compressor, and the core shaft may be a first core shaft. The engine core may further comprise a second turbine, a second compressor, and a second core shaft connecting the second turbine to the second compressor. The second turbine, second compressor, and second core shaft may be arranged to rotate at a higher rotational speed than the first core shaft.

In such an arrangement, the second compressor may be positioned axially downstream of the first compressor. The second compressor may be arranged to receive (for example directly receive, for example via a generally annular duct) flow from the first compressor. The gearbox may be arranged to be driven by the core shaft that is configured to rotate (for example in use) at the lowest rotational speed (for example the first core shaft in the example above). For example, the gearbox may be arranged to be driven only by the core shaft that is configured to rotate (for example in use) at the lowest rotational speed (for example only be the first core shaft, and not the second core shaft, in the example above). Alternatively, the gearbox may be arranged to be driven by any one or more shafts, for example the first and/or second shafts in the example above.

The gearbox may be a reduction gearbox (in that the output to the fan is a lower rotational rate than the input from the core shaft). Any type of gearbox may be used. For example, the gearbox may be a "planetary" or "star" gearbox, as described in more detail elsewhere herein. The gearbox may have any desired reduction ratio (defined as the rotational speed of the input shaft divided by the rotational speed of the output shaft), for example greater than 2.5, for example in the range of from 3 to 4.2, or 3.2 to 3.8, for example on the order of or at least 3, 3.1, 3.2, 3.3, 3.4, 3.5, 3.6, 3.7, 3.8, 3.9, 4, 4.1 or 4.2. The gear ratio may be, for example, between any two of the values in the previous sentence. Purely by way of example, the gearbox may be a "star" gearbox having a ratio in the range of from 3.1 or 3.2 to 3.8.. In some arrangements, the gear ratio may be outside these ranges.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### Brief description of the drawings

Embodiments will now be described by way of example only, with reference to the Figures, in which:
**Figure 1** is a sectional side view of a gas turbine engine.
**Figure 2** is a close up sectional side view of an upstream portion of a gas turbine engine.
**Figure 3** is a partially cut-away view of a gearbox for a gas turbine engine.
**Figure 4** is an enlarged cut away perspective view of part of a turbine for a gas turbine engine.
**Figure 5** is a further enlarged perspective view of a turbine vane segment shown in figure 4.
**Figure 6** is a further enlarged perspective view of a turbine vane.
**Figure 7** is a flow chart of a method of applying a ceramic coating onto a metallic article according to the present disclosure.
**Figure 8(a)** is a schematic diagram illustrating producing a compressive residual stress into the surface of a concave surface of the metallic article after removing alumina using a caustic solution and before applying a ceramic coating to a turbine blade.
**Figure 8(b)** is a schematic diagram illustrating producing a compressive residual stress into the surface of a convex surface of the metallic article after removing alumina using a caustic solution and before applying a ceramic coating to a turbine blade.
**Figure 8(c)** is a schematic diagram illustrating producing a compressive residual stress into the surface of a leading edge of the metallic article after removing alumina using a caustic solution and before applying a ceramic coating to a turbine blade.
**Figure 8(d)** is a schematic diagram illustrating producing a compressive residual stress into the surface of a platform and a radius between a platform and aerofoil of the metallic article after removing alumina using a caustic solution and before applying a ceramic coating to a turbine blade.
**Figure 8(e)** is a schematic diagram illustrating producing a compressive residual stress into the surface of a tip of the metallic article after removing alumina using a caustic solution and before applying a ceramic coating to a turbine blade.
**Figure 9** is a flow chart of a further method of applying a ceramic coating onto a metallic article according to the present disclosure.

### Detailed description

Embodiments will now be described by way of example only, with reference to the Figures.

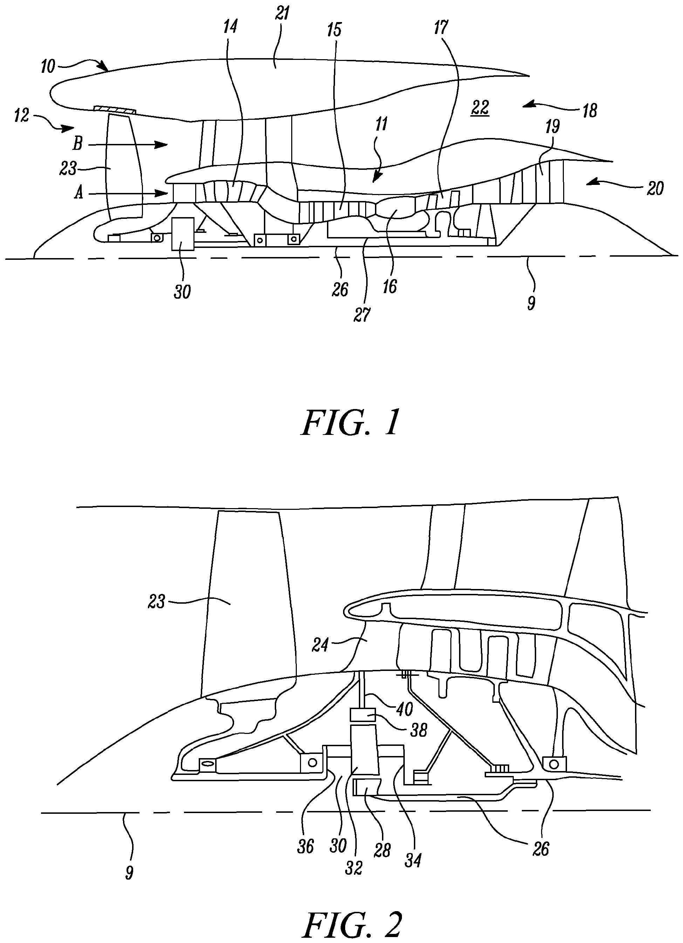

Figure 1 illustrates a gas turbine engine 10 having a principal rotational axis 9. The engine 10 comprises an air intake 12 and a propulsive fan 23 that generates two airflows: a core airflow A and a bypass airflow B. The gas turbine engine 10 comprises a core 11 that receives the core airflow A. The engine core 11 comprises, in axial flow series, a low pressure compressor 14, a high-pressure compressor 15, combustion equipment 16, a high-pressure turbine 17, a low pressure turbine 19 and a core exhaust nozzle 20. A nacelle 21 surrounds the gas turbine engine 10 and defines a bypass duct 22 and a bypass exhaust nozzle 18. The bypass airflow B flows through the bypass duct 22. The fan 23 is attached to and driven by the low pressure turbine 19 via a shaft 26 and an epicyclic gearbox 30.

In use, the core airflow A is accelerated and compressed by the low pressure compressor 14 and directed into the high pressure compressor 15 where further compression takes place. The compressed air exhausted from the high pressure compressor 15 is directed into the combustion equipment 16 where it is mixed with fuel and the mixture is combusted. The resultant hot combustion products then expand through, and thereby drive, the high pressure and low pressure turbines 17, 19 before being exhausted through the nozzle 20 to provide some propulsive thrust. The high pressure turbine 17 drives the high pressure compressor 15 by a suitable interconnecting shaft 27. The fan 23 generally provides the majority of the propulsive thrust. The epicyclic gearbox 30 is a reduction gearbox.

An exemplary arrangement for a geared fan gas turbine engine 10 is shown in Figure 2. The low pressure turbine 19 (see Figure 1) drives the shaft 26, which is coupled to a sun wheel, or sun gear, 28 of the epicyclic gear arrangement 30. Radially outwardly of the sun gear 28 and intermeshing therewith is a plurality of planet gears 32 that are coupled together by a planet carrier 34. The planet carrier 34 constrains the planet gears 32 to precess around the sun gear 28 in synchronicity whilst enabling each planet gear 32 to rotate about its own axis. The planet carrier 34 is coupled via linkages 36 to the fan 23 in order to drive its rotation about the engine axis 9. Radially outwardly of the planet gears 32 and intermeshing therewith is an annulus or ring gear 38 that is coupled, via linkages 40, to a stationary supporting structure 24.

Note that the terms "low pressure turbine" and "low pressure compressor" as used herein may be taken to mean the lowest pressure turbine stages and lowest pressure compressor stages (i.e. not including the fan 23) respectively and/or the turbine and compressor stages that are connected together by the interconnecting shaft 26 with the lowest rotational speed in the engine (i.e. not including the gearbox output shaft that drives the fan 23). In some literature, the "low pressure turbine" and "low pressure compressor" referred to herein may alternatively be known as the "intermediate pressure turbine" and "intermediate pressure compressor". Where such alternative nomenclature is used, the fan 23 may be referred to as a first, or lowest pressure, compression stage.

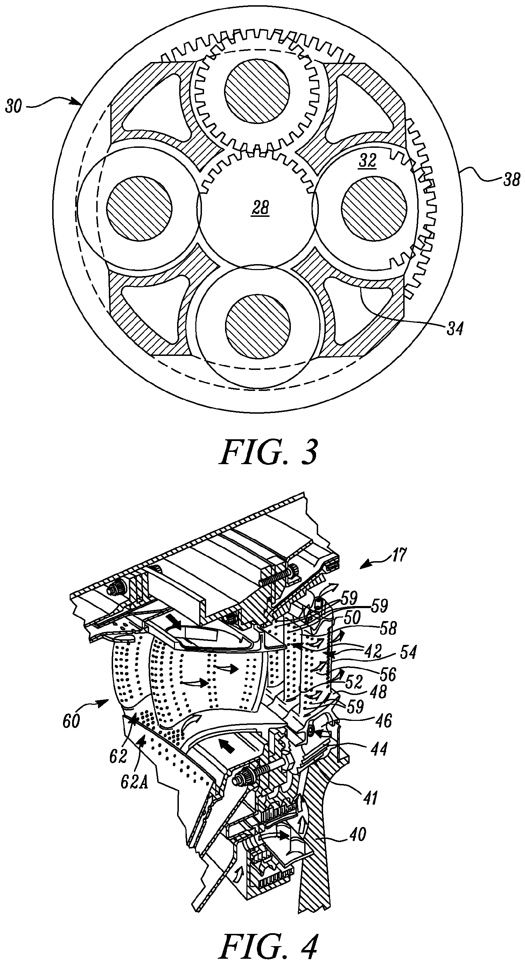

The epicyclic gearbox 30 is shown by way of example in greater detail in Figure 3. Each of the sun gear 28, planet gears 32 and ring gear 38 comprise teeth about their periphery to intermesh with the other gears. However, for clarity only exemplary portions of the teeth are illustrated in Figure 3. There are four planet gears 32 illustrated, although it will be apparent to the skilled reader that more or fewer planet gears 32 may be provided within the scope of the claimed invention. Practical applications of a planetary epicyclic gearbox 30 generally comprise at least three planet gears 32.

The epicyclic gearbox 30 illustrated by way of example in Figures 2 and 3 is of the planetary type, in that the planet carrier 34 is coupled to an output shaft via linkages 36, with the ring gear 38 fixed. However, any other suitable type of epicyclic gearbox 30 may be used. By way of further example, the epicyclic gearbox 30 may be a star arrangement, in which the planet carrier 34 is held fixed, with the ring (or annulus) gear 38 allowed to rotate. In such an arrangement the fan 23 is driven by the ring gear 38. By way of further alternative example, the gearbox 30 may be a differential gearbox in which the ring gear 38 and the planet carrier 34 are both allowed to rotate.

It will be appreciated that the arrangement shown in Figures 2 and 3 is by way of example only, and various alternatives are within the scope of the present disclosure. Purely by way of example, any suitable arrangement may be used for locating the gearbox 30 in the engine 10 and/or for connecting the gearbox 30 to the engine 10. By way of further example, the connections (such as the linkages 36, 40 in the Figure 2 example) between the gearbox 30 and other parts of the engine 10 (such as the input shaft 26, the output shaft and the fixed structure 24) may have any desired degree of stiffness or flexibility. By way of further example, any suitable arrangement of the bearings between rotating and stationary parts of the engine (for example between the input and output shafts from the gearbox and the fixed structures, such as the gearbox casing) may be used, and the disclosure is not limited to the exemplary arrangement of Figure 2. For example, where the gearbox 30 has a star arrangement (described above), the skilled person would readily understand that the arrangement of output and support linkages and bearing locations would typically be different to that shown by way of example in Figure 2.

Accordingly, the present disclosure extends to a gas turbine engine having any arrangement of gearbox styles (for example star or planetary), support structures, input and output shaft arrangement, and bearing locations.

Optionally, the gearbox may drive additional and/or alternative components (e.g. the intermediate pressure compressor and/or a booster compressor).

Other gas turbine engines to which the present disclosure may be applied may have alternative configurations. For example, such engines may have an alternative number of compressors and/or turbines and/or an alternative number of interconnecting shafts. By way of further example, the gas turbine engine shown in Figure 1 has a split flow nozzle 18, 20 meaning that the flow through the bypass duct 22 has its own nozzle 18 that is separate to and radially outside the core exhaust nozzle 20. However, this is not limiting, and any aspect of the present disclosure may also apply to engines in which the flow through the bypass duct 22 and the flow through the core 11 are mixed, or combined, before (or upstream of) a single nozzle, which may be referred to as a mixed flow nozzle. One or both nozzles (whether mixed or split flow) may have a fixed or variable area. Whilst the described example relates to a turbofan engine, the disclosure may apply, for example, to any type of gas turbine engine, such as an open rotor (in which the fan stage is not surrounded by a nacelle) or turboprop engine, for example. In some arrangements, the gas turbine engine 10 may not comprise a gearbox 30.

The geometry of the gas turbine engine 10, and components thereof, is defined by a conventional axis system, comprising an axial direction (which is aligned with the rotational axis 9), a radial direction (in the bottom-to-top direction in Figure 1), and a circumferential direction (perpendicular to the page in the Figure 1 view). The axial, radial and circumferential directions are mutually perpendicular.

Figure 4 shows part of the high-pressure turbine 17 of the gas turbine engine 10. The high-pressure turbine 17 comprises a turbine disc 40 which carries a plurality of circumferentially spaced radially outwardly extending turbine blades 42. Each turbine blade 42 comprises a root 44, a shank, 46, a platform 48 and an aerofoil 50. The aerofoil 50 of each turbine blade 42 comprises a leading edge 52, a trailing edge 54, a convex surface 56 which extends from the leading edge 52 to the trailing edge 54 and from the platform 48 and a concave surface 58 which extends from the leading edge 52 to the trailing edge 54 and from the platform 48. The root 44 of each turbine blade 42 locates in a slot 41 in the rim of the turbine disc 40. The root 44 of each turbine blade 42 may be a firtree shaped root or a dovetail shaped root and locates in a correspondingly shaped slot 41 in the rim of the turbine disc 40. The aerofoil 50 of each turbine blade 42 has a plurality of apertures 59 extending there-through and which are arranged in operation to provide film cooling of the aerofoil 50, e.g. to provide a film of coolant, e.g. air, onto the leading edge 52, the convex surface 56 or the concave surface 58 of the aerofoil 50. The turbine blades 42 comprise a metal substrate, for example a superalloy, e.g. a nickel based superalloy, a cobalt based superalloy or an iron based superalloy. The metal substrate of the turbine blades 42 may be a single crystal, a directionally solidified or an equiaxed metal. The turbine blades 42 are produced by investment casting. The apertures 59 are provided in the aerofoil 50 by electro-discharge machining or laser machining of the casting.

Each turbine blade 42 is a ceramic coated metallic article. Each turbine blade 42 has a metallic bond coating and a ceramic coating on the metallic bond coating. The metallic bond coating is provided on the gas washed surfaces of the aerofoil 50 and the gas washed surface of the platform 48. The metallic bond coating may have the same composition on the gas washed surfaces of the aerofoils, a first portion, and on the gas washed surface of the platform, a second portion. The ceramic coating is provided on the metallic bond coating. The ceramic coating on the second portion has the same composition as the ceramic coating on the first portion.

The high-pressure turbine 17 also comprises a stage of turbine nozzle guide vanes 60 which direct hot gases from the combustion equipment 16 into the high-pressure turbine 17. The stage of turbine nozzle guide vanes 60 comprises either a plurality of circumferentially arranged turbine vane segments 62 or a plurality of circumferentially arranged turbine vanes 62A.

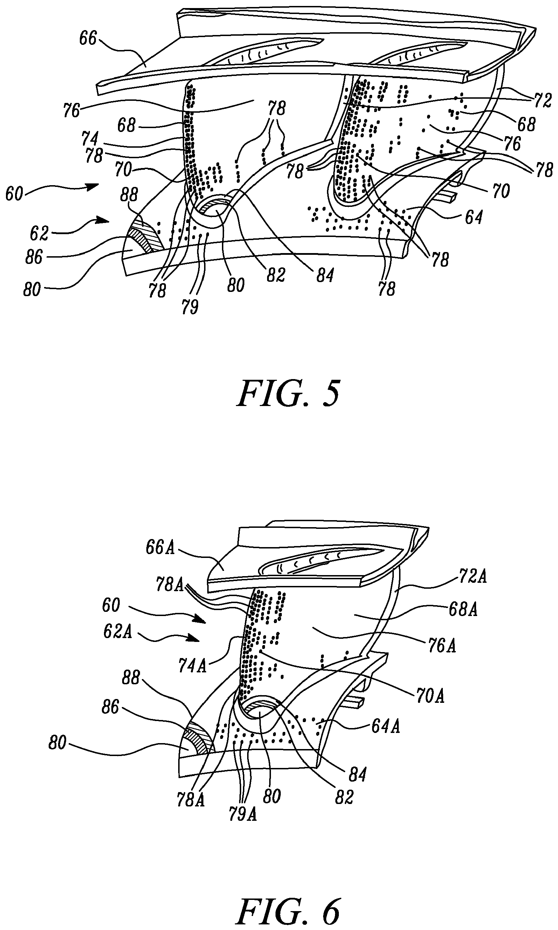

Figure 5 shows a turbine vane segment 62. Each turbine vane segment 62 comprises a first, an inner, platform 64, a second, an outer, platform 66 and a plurality of aerofoils 68 and each aerofoil 68 extends between and is secured to the first and second platforms 64 and 66 respectively. Each aerofoil 68 of the turbine vane segment 62 comprises a leading edge 70, a trailing edge 72, a convex surface 74 which extends from the leading edge 70 to the trailing edge 72 and from the first platform 64 to the second platform 66 and a concave surface 76 which extends from the leading edge 70 to the trailing edge 72 and from the first platform 64 to the second platform 66. In this example each turbine vane segment 62 comprises two aerofoils 68 but each turbine vane segment 62 may have three or more aerofoils 68. Each aerofoil 68 of the turbine vane segment 62 has a plurality of apertures 78 extending there-through and which are arranged in operation to provide film cooling of the aerofoil 68, e.g. to provide a film of coolant, e.g. air, onto the leading edge 70, the convex surface 74 or the concave surface 76 of the aerofoil 68. The first and second platforms 64 and 66 of the turbine vane segment 62 have a plurality of apertures 798 extending there-through and which are arranged in operation to provide film cooling of the first and second platform 64 and 66, e.g. to provide a film of coolant, e.g. air, onto the first and second platforms 64 and 66. The turbine vane segments 62 comprise a metal substrate 80, for example a superalloy, e.g. a nickel based superalloy, a cobalt based superalloy or an iron based superalloy. The metal substrate of the turbine vane segment 62 may be a single crystal, a directionally solidified or an equiaxed metal. Each turbine vane segment 62 is a ceramic coated metallic article. The turbine vane segments 62 are produced by investment casting.

The apertures 78 and 79 are provided in the aerofoils 68 and first and second platforms 64 and 66 by electro-discharge machining or laser machining of the casting.

Each turbine vane segment 62 is a ceramic coated metallic article. A first portion of the each turbine vane segment 62 has a metallic bond coating and a columnar grain ceramic coating on the metallic bond coating and a second portion of each turbine vane segment 62 has a metallic bond coating and a ceramic coating on the metallic bond coating. The ceramic coating on the second portion has the same composition as the ceramic coating on the first portion. The ceramic coating on the first portion may have a different composition to the ceramic coating on the second portion. The first portion of each turbine vane segment 62 comprises the aerofoils 68, e.g. the gas washed surfaces of the aerofoils 68, and the second portion of the turbine vane segment 62 comprises the first and second platforms 64 and 66, e.g. the gas washed surfaces of the platform 64 and 66.

Figure 6 shows a turbine vane 62A. Each turbine vane 62A comprises a first, an inner, platform 64A, a second, an outer, platform 66A and a single aerofoil 68A which extends between and is secured to the first and second platforms 64A and 66A respectively. The aerofoil 68A of the turbine vane 62A comprises a leading edge 70A, a trailing edge 72A, a convex surface 74A which extends from the leading edge 70A to the trailing edge 72A and from the first platform 64A to the second platform 66A and a concave surface 76A which extends from the leading edge 70A to the trailing edge 72A and from the first platform 64A to the second platform 66A. The aerofoil 68A of the turbine vane 62A has a plurality of apertures 78A extending there-through and which are arranged in operation to provide film cooling of the aerofoil 68A, e.g. to provide a film of coolant, e.g. air, onto the leading edge 70A, the convex surface 74A or the concave surface 76A of the aerofoil 68A. The first and second platforms 64A and 66A of the turbine vane 62A have a plurality of apertures 79A extending there-through and which are arranged in operation to provide film cooling of the first and second platform 64A and 66A, e.g. to provide a film of coolant, e.g. air, onto the first and second platforms 64A and 66A. The turbine vanes 62A comprise a metal substrate 80, for example a superalloy, e.g. a nickel based superalloy, a cobalt based superalloy or an iron based superalloy. The metal substrate of the turbine vane 62A may be a single crystal, a directionally solidified or an equiaxed metal. Each turbine vane 62A is a ceramic coated metallic article. The turbine vanes 62A are produced by investment casting. The apertures 78A and 79A are provided in the aerofoils 68A and the first and second platforms 64A and 66A by electro-discharge machining or laser machining of the casting.

Each turbine vane 62A is a ceramic coated metallic article. A first portion of the each turbine vane 62A has a metallic bond coating and a columnar grain ceramic coating on the metallic bond coating and a second portion of each turbine vane 62A has a metallic bond coating and a ceramic coating on the metallic bond coating. The ceramic coating on the second portion has the same composition as the ceramic coating on the first portion. The ceramic coating on the first portion may have a different composition to the ceramic coating on the second portion. The first portion of each turbine vane 62A comprises the aerofoil 68A, e.g. the gas washed surfaces of the aerofoil 68A, and the second portion of the turbine vane 62A comprises the first and second platforms 64A and 66A e.g. the gas washed surfaces of the platform 64A and 66A.

Figures 5 and 6 show the metallic bond coating 82 on the first portion and the metallic bond coating 86 on the second portion of a turbine vane segment 62 and turbine vane 62A and in this example they are different, but it is possible the metallic bond coating 82 on the first portion and the metallic bond coating 86 on the second portion are the same. The metallic bond coating 82 on the first portion comprises a platinum-group metal. The metallic bond coating 86 on the second portion is an overlay coating or an aluminide coating. The overlay coating comprises a MCrAlY coating, a MCrAI coating or a MAI coating, where M is one or more of nickel, cobalt and iron, Cr is chromium, Al is aluminium and Y is one or more of yttrium, ytterbium and lanthanum. In the case of a turbine blade 42 the aerofoil 50 and the platform 48 may have a bond coating having the same composition, e.g. the metallic bond coating may comprise a platinum-group metal.

The metallic bond coating 86 on the second portion may comprise a layer of platinum-group metal between the second portion of the metallic article and the overlay coating. The metallic bond coating 82 on the first portion may comprise a layer of aluminium diffused into the layer of platinum-group metal to form a platinum-group metal aluminide coating, e.g. platinum aluminide. The layer of platinum-group metal may be deposited by electroplating, or other suitable method, and then is heat treated to diffuse the platinum-group metal into the metallic article to produce a platinum-group metal enriched outer layer of the metallic article, e.g. a platinum metal enriched outer layer of the metallic article. In the case of a nickel based superalloy, the platinum-group metal enriched outer layer of the metallic article may comprise a platinum-group metal enriched gamma prime phase and a platinum-group metal enriched gamma prime phase, e.g. a platinum enriched gamma prime phase and a platinum enriched gamma prime phase.

Figures 5 and 6 show the columnar grain ceramic coating 84 on the metallic bond coating 82 on the first portion and the ceramic coating 88 on the metallic bond coating 86 on the second portion. The columnar grain ceramic coating 84 may have been deposited by physical vapour deposition, e.g. by electron beam physical vapour deposition. The ceramic coating 88 may have been deposited by thermal spraying, e.g. air plasma spraying, vacuum plasma spraying, high-velocity oxy-fuel spraying etc. The ceramic coating may comprise yttria stabilised zirconia. The ceramic coating may comprise zirconia stabilised with ceria, ytterbia or india. The ceramic coating may comprise zirconia stabilised with yttria and erbia. The ceramic coating may comprise zirconia stabilised with yttria, erbia and gadolinia. The ceramic coating may comprise zirconia stabilised with yttria and gadolinia. The ceramic coating 84 on the first portion and the ceramic coating 88 on the second portion may have the same composition or they may have a different composition.

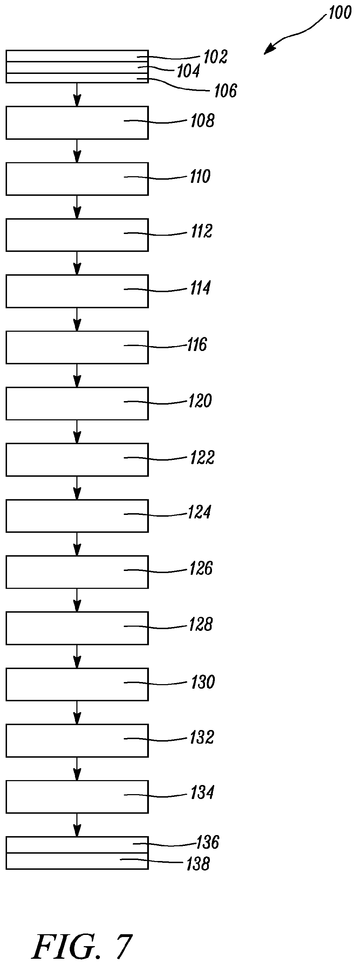

A method of applying a ceramic coating onto a metallic article 100 is shown in figure 7. The metallic article 42, 62, 62A has a first portion and a second portion, the first portion having a metallic bond coating 82 and a ceramic coating 84 on the metallic bond coating 82 and the second portion having a metallic bond coating 86 and a ceramic coating 88 on the metallic bond coating 86. The ceramic coating 88 on the second portion is different to the ceramic coating 84 on the first portion. The metallic bond coating 86 on the second portion is different to the metallic bond coating 82 on the first portion. In this example the metallic bond coating 82 comprises a platinum-group metal enriched outer layer of the metallic article 42, 62, 62A and the metallic bond coating 86 comprises a platinum-group metal enriched outer layer of the metallic article 42, 62, 62A and an overlay coating on the platinum-group metal enriched outer layer of the metallic article 42, 62, 62A. In this example the ceramic coating 84 comprises a columnar grain ceramic coating and the ceramic coating 88 comprises a lamellae ceramic coating.

The method of applying a ceramic coating onto the metallic article 100 comprises a first step 102 of immersing the metallic article 42, 62, 62A in a caustic solution, the caustic solution comprising one of potassium hydroxide and sodium hydroxide, a second step 104 of maintaining the metallic article in the caustic solution at atmospheric pressure for a predetermined time period and at a predetermined temperature. The first step 102 comprises immersing the metallic article 42, 62, 62A in a caustic solution of 46 to 54% potassium hydroxide or a caustic solution of 46 to 54% sodium hydroxide. The second step 104 comprises maintaining the metallic article 42, 62, 62A in the caustic solution at atmospheric pressure for a time equal to or more than half an hour and equal to or less than one and a half hours at a temperature equal to or greater than 150°C and equal to or less than 250 °C to weaken a bond between any alumina on the surface of the metallic article 42, 62, 62A and the metallic article 42, 62, 62A. In particular the second step 104 comprises maintaining the metallic article 42, 62, 62A in the caustic solution at atmospheric pressure for a time equal to or less than an hour at a temperature equal to or greater than 200 °C and equal to or less than 220 °C. The caustic solution is able to remove, or weaken, any alumina attached or trapped on the surface of the metallic article 42, 62, 62A. Thus, the caustic solution is able to remove, or weaken, the recast layer of alumina around cooling apertures extending through the metallic article 42, 62, 62A or any alumina particles on the surface of the metallic article 42, 62, 62A. The second step provides sufficient time to allow the caustic solution to weaken the oxide layer or oxide particles, alumina layer or alumina particles, on the metallic article 42, 62, 62A.

A third step 106 of removing the metallic article 42, 62, 62A from the caustic solution and a fourth step 108 of rinsing the metallic article 42, 62, 62A in water at ambient temperature. The fourth step 108 comprises rinsing the metallic article 42, 62, 62A in water for a minimum of 10 minutes. The fourth step 108 of rinsing the metallic article 42, 62, 62A in water at ambient temperature produces a thermal shock to further weaken the bond between any alumina on the surface of the metallic article 42, 62, 62A and the metallic article 42, 62, 62A. A fifth step 110 of neutralising the caustic solution with a weak acid and a sixth step 112 of rinsing the metallic article 42, 62, 62A in water. The fifth step 110 comprises neutralising the caustic solution with nitric acid solution with a concentration of 25 to 35% for about 20 minutes, but other suitable acids may be used. The sixth step 112 of rinsing the metallic article 42, 62, 62A in water comprises rinsing in water at ambient temperature for 5 minutes and rinsing in warm water at a temperature equal to or greater than 75 °C and equal to or less than 85 °C.

A seventh step 114 of water jet blasting at mains water pressure to dislodge any debris from the metallic article 42, 62, 62A and an eighth step 116 of rinsing in water. The eighth step 116 comprises rinsing the metallic article 42, 62, 62A in warm water at a temperature equal to or greater than 75 °C and equal to or less than 85 °C for about 5 seconds to dry the metallic article 42, 62, 62A.

A ninth step 118 of chemical cleaning of the metallic article 42, 62, 62A. The chemical cleaning comprises cleaning the surface of the metallic article 42, 62, 62A using a solvent and a detergent. The solvent dissolves contaminants, e.g. oil, grease, oxides, etc., from internal surfaces and external surfaces of the metallic article 42, 62, 62A. The detergent emulsifies and encapsulates contaminants and they are washed away.

A tenth step 120 of burning off, pyrolysis of, organic material from internal surfaces and external surfaces of the metallic article 42, 62, 62A. The burning off comprises placing the metallic article 42, 62, 62A in an oven and heating the metallic article 42, 62, 62A in a reduced oxygen atmosphere such that any organic material reacts and is broken down to a residue which is subsequently removed.

An eleventh step 122 of water jet peening the metallic article 42, 62, 62A to produce a compressive residual stress in the metallic article 42, 62, 62A. The eleventh step 122 of water jet peening also aids in removing alumina, the recast layer, from apertures in the metallic article 42, 62, 62A and/or removes alumina grit particles from the surface of the metallic article 42, 62, 62A. The eleventh step 122 of water jet peening the metallic article 42, 62, 62A as mentioned above modifies the microstructure of the metallic article 42, 62, 62A to produce a compressive residual stress in the surface of the metallic article 42, 62, 62A and it is believed produces twinning, twin boundary cracks, of the microstructure which promotes enhanced inter-diffusion of the platinum-group metal in the surface of the metal article 42, 62, 62A.

The eleventh step 122 comprises water jet peening the metallic article 42, 62, 62A by directing water at the metallic article 42, 62, 62A from a nozzle, a water jet nozzle, at a pressure of 275 to 296 MPa (40,000 to 43,000 psi), arranging the nozzle, the water jet nozzle, at a stand-off distance from the metallic article 42, 62, 62A of 20 to 30 mm and traversing the nozzle, the water jet nozzle, over the metallic article 42, 62, 62A at a speed of 2.5 to 3.8 mm per second. The water jet peening is arranged such that water droplets impact upon the metallic article. The eleventh step 122 of water jet peening may comprise water jet peening the metallic article 42, 62, 62A by directing water at the metallic article 42, 62, 62A from a nozzle at a pressure of 275 to 290 MPa (40,000 to 42,000 psi), arranging the nozzle at a stand-off distance from the metallic article 42, 62, 62A of 22 to 28 mm and traversing the nozzle over the metallic article 42, 62, 62A at a speed of 2.7 to 3.5 mm per second. The eleventh step 122 comprising directing water droplets with a diameter of 17 to 18 µm with a velocity of 650 ms⁻¹ to 690 ms⁻¹ onto the metallic article 42, 62, 62A. The eleventh step 122 comprises directing water droplets onto the metallic article 42, 62, 62A to produce an impact pressure of equal to more than 10 GPa and equal to or less than 14 GPa. The eleventh step 122 may comprise directing water droplets onto the metallic article 42, 62, 62A to produce an impact pressure of equal to more than 11 GPa and equal to or less than 13.5 GPa. The eleventh step 122 comprises directing water droplets onto the metallic article 42, 62, 62A to produce a compressive residual stress to a depth of 60 µm from the surface of the metallic article of equal to or more than 1000 MPa and equal to or less than 1200 MPa.

In a first example the eleventh step 122 comprises water jet peening the metallic article 42, 62, 62A by directing water at the metallic article 42, 62, 62A from a nozzle at a pressure of 284.7MPa (41,300 psi), arranging the nozzle at a stand-off distance from the metallic article 42, 62, 62A of 25 mm and traversing the nozzle over the metallic article 42, 62, 62A at a speed of 2.9 mm per second. In this example the water jet peening is directed onto the surfaces of the aerofoil 50, 68, 68A of the metallic article 42, 62, 62A. In the first example the eleventh step 122 comprises directing water droplets onto the metallic article 42, 62, 62A to produce an impact pressure of equal to 13.0 GPa, e.g. the water jet peening is directed onto the surfaces of the aerofoil 50, 68 of the metallic article 42, 62, 62A. In the first example eleventh step 122 comprises directing water droplets onto the metallic article 42, 62, 62A to produce a compressive residual stress of 1170 MPa to a depth of 60 µm from the surface of the metallic article, e.g. the water jet peening is directed onto the surfaces of the aerofoil 50, 68, 68A of the metallic article 42, 62, 62A.

In a second example the eleventh step 122 comprises water jet peening the metallic article 42, 62, 62A by directing water at the metallic article 42, 62, 62A from a nozzle at a pressure of 284.7 MPa (41,300 psi), arranging the nozzle at a stand-off distance from the metallic article 42, 62, 62A of 25mm and traversing the nozzle over the metallic article 42, 62, 62A at a speed of 3.3 mm per second. In this example the water jet peening is directed onto the surface of the platforms 48, 64, 66, 64A, 66A of the metallic article 42, 62, 62A. In the second example the eleventh step 122 comprises directing water droplets onto the metallic article 42, 62, 62A to produce an impact pressure of equal to 11.3 GPa, e.g. the water jet peening is directed onto the surface of the platforms 48, 64, 66, 64A, 66A of the metallic article 42, 62, 62A. In the second example the eleventh step 122 comprises directing water droplets onto the metallic article 42, 62, 62A to produce a compressive residual stress of 1024 MPa to a depth of 60 µm from the surface of the metallic article, e.g. the water jet peening is directed onto the surface of the platforms 48, 64, 66, 64A, 66A of the metallic article 42, 62, 62A.

In the eleventh step 122 the nozzle, the water jet nozzle, may be rotated around an axis, which axis, at 1000 rpm +/- 100 rpm. In the eleventh step 122 the nozzle, the water jet nozzle, has an orifice with a diameter of 0.58 mm. In the eleventh step 122 the nozzle, the water jet nozzle, has a conical fan jet orifice. In the eleventh step 122 the nozzle, the water jet nozzle, is mounted on a six axis robot to enable the nozzle to direct the water onto the metallic article 42, 62, 62A.

A twelfth step 124 comprises ultrasonic cleaning of the metal article 42, 62, 62A. The ultrasonic cleaning step 124 comprises immersing the metallic article 42, 62, 62A in a weak acid and agitating the weak acid using ultrasonic signals to generate cavitation in the weak acid. The weak acid may comprise citric acid. The ultrasonic cleaning process uses a weak acid solution for the removal of intrinsic oxides, rust, and scales. The metal article 42, 62, 62A is immersed in this chemical solution, induced by high frequency pressure (sound) waves to agitate the liquid. During agitation, bubbles are produced, which travels at high velocity towards the surface of the metal article 42, 62, 62A, where they implode on impact with enormous amount of energy. During implosion, the cavitation process takes place, lifting the contaminants from the surface of the metal article 42, 62, 62A by gentle scrubbing action.

A thirteenth step 126 comprises depositing a bond coating onto the metallic article 42, 62, 62A. The thirteenth step comprises applying a layer of platinum-group metal onto the metal article 42, 62, 62A. In this example a layer of platinum-group metal is applied onto the gas washed surfaces of the aerofoils 50, 68, 68A and the platforms 48, 64, 66, 64A, 66A of the metallic articles 42, 62, 62A. The layer of platinum-group metal, e.g. platinum, is applied onto the gas washed surfaces of the aerofoils 50, 68, 68A and the platforms 48, 64, 66, 64A, 66A of the metallic articles 42, 62, 62A by electroplating or other suitable method, e.g. sputtering, physical vapour deposition or chemical vapour deposition.

A fourteenth step 128 comprises heat treating the bond coating and metallic article 42, 62, 62A. The fourteenth step 128 comprises heat treating the metal article 42, 62, 62A to diffuse the platinum group metal, e.g. platinum, into the metallic article to form a platinum group metal enriched outer layer on the metal article 42, 62, 62A, e.g. an outer layer comprising platinum group metal enriched gamma prime phase in a platinum group metal enriched gamma phase matrix. The fourteenth step 128 comprises heating at a temperature of 1100 °C to 1200 °C, for example heating at a temperature of 1150 °C to 1200 °C.

A fifteenth step 130 comprises grit blasting the platinum group metal enriched outer layer on the metal article 42, 62, 62A or water jet blasting the platinum group metal enriched outer layer on the metal article 42, 62, 62A. The grit blasting may comprise using alumina grit, but this has a disadvantage of contaminating the surface of the platinum group metal enriched outer layer on the metal article 42, 62, 62A with alumina grit which may roughen the surface and affect the phase structure of the subsequently thermally grown oxide layer. The water jet blasting work hardens the platinum group metal enriched outer layer on the metal article 42, 62, 62A, promotes diffusion of alumina outwards to enhance the phase structure of the subsequently thermally grown oxide layer and smooths the surface. The water jet blasting comprises directing water at the platinum group metal enriched outer layer on the aerofoil 50, 68, 68A of the metallic article 42, 62, 62A from a nozzle at a pressure of 275 to 296 MPa (40,000 to 43,000 psi), arranging the nozzle at a stand-off distance from the metallic article 42, 62, 62A of 33 to 37 mm and traversing the nozzle over the platinum group metal enriched outer layer on the metallic article 42, 62, 62A at a speed of 4.5 to 5.5 mm per second at an impact angle of 90°. The water jet blasting may comprise directing water at the platinum group metal enriched outer layer on the platform or platforms 48, 66, 66A of the metallic article 42, 62, 62A from a nozzle at a pressure of 275 to 290 MPa (40,000 to 42,000 psi), arranging the nozzle at a stand-off distance from the platinum group metal enriched outer layer on the metallic article 42, 62, 62A of 38 to 42 mm and traversing the nozzle over the platinum group metal enriched outer layer on the metallic article 42, 62, 62A at a speed of 6.2 to 7.2 mm per second at an impact angle of 90°. The water jet blasting parameters are different due to the difference in values of the Young's Modulus and yield strength, dependent upon the crystal lattice orientation of the metallic article 42, 62, 62A at the aerofoil 50, 68, 68A and the platform 48, 66, 66A. The crystal growth of a single crystal in a single crystal turbine blade, or single crystal turbine vane, is aligned with the radial direction.

A sixteenth step 132 comprises preheating the metal article 42, 62, 62A in an oxygen environment before applying the ceramic coating to thermally grow a thin metal oxide, e.g. alumina, layer on the platinum group metal enriched outer layer on the metal article 42, 62, 62A. The fifteenth step 130 comprises heating the metal article 42, 62, 62A to a temperature of at least 900 °C. The fourteenth step 130 may preheat the metal article 42, 62, 62A to a temperature of at least 1000 °C. It is preferred to preheat the metal article 42, 62, 62A to a temperature of at least 1100 °C, for example to a temperature in the range of 1150 °C to 1200 °C to form a stable alpha alumina phase layer on the platinum group metal enriched outer layer on the metal article 42, 62, 62A.

A seventeenth step 134 comprises depositing a layer of ceramic coating onto the thin metal oxide layer by physical vapour deposition to form a columnar grain ceramic coating. The columnar grain ceramic coating may be deposited by electron beam physical vapour deposition.

An eighteenth step 136 comprises a stress relief heat treatment. The stress relief heat treatment comprises maintaining the ceramic coated metal article at a temperature of 1100 °C for one hour.

A nineteenth step 138 comprises an age heat treatment. The age heat treatment comprises maintaining the ceramic coated metal article at a temperature of 870 °C for sixteen hours.

The fifth, sixth, seventh, eighth, ninth, tenth, twelfth, fifteenth, eighteenth and nineteenth steps are optional.

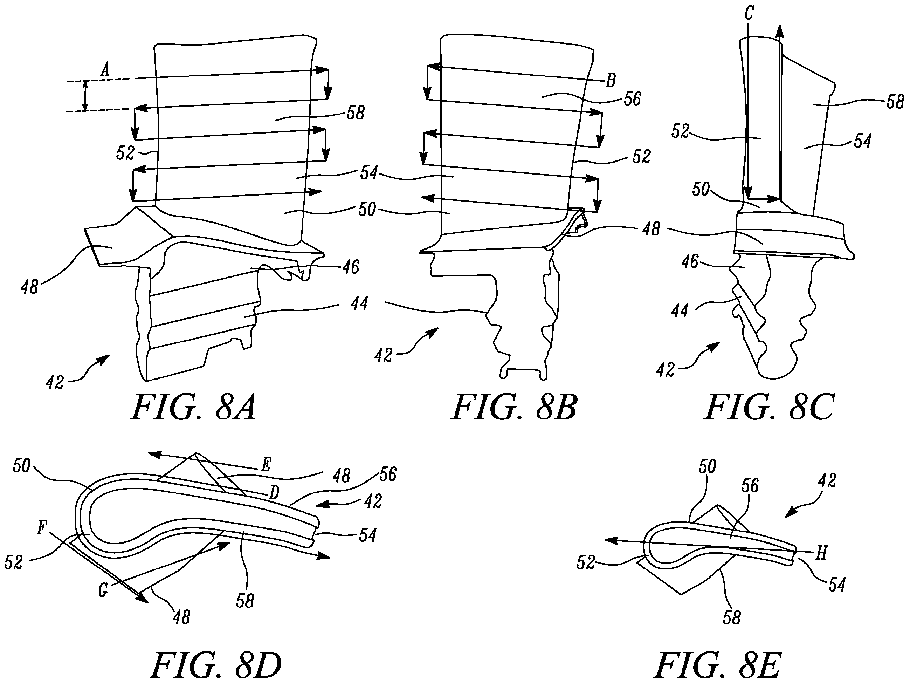

Figures 8(a) to 8(e) show the eleventh step of applying a compressive residual stress in the surface of the metallic article 42, 62, 62A by water jet peening the first portion of the metallic article 42, 62, 62A.

In particular figures 8(a) to 8(e) illustrates water jet peening comprising traversing the nozzle, the water jet nozzle, and hence traversing the water jet, over the surface of a turbine blade 42 to produce a compressive residual stress into the surface of the turbine blade, metallic article, 42. A first pass A as shown in Figure 8(a) comprises traversing the nozzle, and hence traversing the water jet over the concave surface 58 of the aerofoil 50 of the turbine blade 42 repeatedly back and forth, or reciprocating the nozzle, over the concave surface 58 of the aerofoil 50 of the turbine blade 42 in a direction between the leading and trailing edges 52 and 54 with the back and forth traverses spaced apart in a direction between the platform 48 and a tip of the aerofoil 50. The back and forth traverses are for example spaced apart by 9mm. The passes of the water jet may be arranged to overlap by 50%. The water jet is arranged to impinge perpendicularly upon the concave surface 58 of the aerofoil 50 of the turbine blade 42. The back and forth traverses of the nozzle and water jet are arranged to produce a uniform compressive residual stress in the concave surface 58 of the aerofoil 50 of the turbine blade 42.

A second pass B as shown in Figure 8(b) comprises traversing the nozzle, and hence traversing the water jet over the convex surface 56 of the aerofoil 50 of the turbine blade 42 repeatedly back and forth, or reciprocating the nozzle, over the convex surface 56 of the aerofoil 50 of the turbine blade 42 in a direction between the leading and trailing edges 52 and 54 with the back and forth traverses spaced apart in a direction between the platform 48 and the tip of the aerofoil 50. The back and forth traverses are for example spaced apart by 9 mm. The passes of the water jet may be arranged to overlap by 50%. The water jet is arranged to impinge perpendicularly upon the convex surface 56 of the aerofoil 50 of the turbine blade 42. The back and forth traverses of the nozzle and water jet are arranged to produce a uniform compressive residual stress in the convex surface 56 of the aerofoil 50 of the turbine blade 42.

A third pass C as shown in Figure 8(c) comprises traversing the nozzle, and hence traversing the water jet over the convex surface 56 of the aerofoil 50 of the turbine blade 42 back and forth, or reciprocating the nozzle, over the leading edge 52 of the aerofoil 50 of the turbine blade 42 in a direction between the platform 48 and the tip with the back and forth traverses spaced apart. The back and forth traverses are for example spaced apart by 9mm. The passes of the water jet may be arranged to overlap by 50%. The water jet is arranged to impinge perpendicularly upon the leading edge 52 of the aerofoil 50 of the turbine blade 42. The back and forth traverses of the nozzle and water jet are arranged to produce a uniform compressive residual stress in the leading edge 52 of the aerofoil 50 of the turbine blade 42.

A fourth pass D as shown in Figure 8(d) comprises traversing the nozzle, and hence the water jet over the radius at the interface between the aerofoil 50 and the platform 48 in a chordal direction from the trailing edge 54 to leading edge 52 along the convex surface 56 and from leading edge 52 to the trailing edge 54 along the concave surface 58. The water jet is arranged to impinge at 75° upon the radius at the interface between the aerofoil 50 and the platform 48 of the turbine blade 42.

A fifth pass E as shown in Figure 8(d) comprises traversing the nozzle, and hence the water jet over the platform 48 adjacent to, and spaced from, the convex surface 56 of the aerofoil 50. The water jet is arranged to impinge perpendicularly upon the platform 48 of the turbine blade 42. A sixth pass F as shown in Figure 8(d) comprises traversing the nozzle, and hence the water jet over the platform 48 adjacent to, and spaced from, the convex surface 56 of the aerofoil 50. The water jet is arranged to impinge perpendicularly upon the platform 48 of the turbine blade 42. A seventh pass G as shown in Figure 8(d) comprises traversing the nozzle, and hence the water jet over the platform 48 adjacent to and spaced from, the leading edge 52 of the aerofoil 50. The water jet is arranged to impinge perpendicularly upon the platform 48 of the turbine blade 42.

An eighth pass H as shown in Figure 8(e) comprises traversing the nozzle, and hence the water jet over the tip of the aerofoil 50 in a chordal direction from the trailing edge 54 to leading edge 52. The water jet is arranged to impinge perpendicularly upon a tip wall, a tip gutter defined by the tip wall and a radius at the interface between the tip wall and the tip gutter at the tip of the aerofoil 50 of the turbine blade 42. The tip wall protrudes radially from the tip of the aerofoil 50 and extends continuously from the trailing edge 54 of the aerofoil 50 to the leading edge 52 along the concave side of the aerofoil 50 and then to the trailing edge 54 of the aerofoil 50 along the convex side of the aerofoil 50.

The eight passes A to H are arranged to produce a uniform compressive residual stress into the surface of the turbine blade, metallic article, 42. The eight passes A to H may be performed in any order.

A similar method of water jet peening comprising traversing the nozzle, and hence traversing the water jet, over the surface of a turbine vane 62A to produce a compressive residual stress into the surface of the turbine vane, metallic article, 62A. But this method of water jet peening would not have an eighth pass as described above for a turbine blade 42 but instead would have a ninth, tenth, eleventh and twelfth pass similar to the fourth, fifth, sixth and seventh passes described above performed on the other platform 64A or 66A of the turbine vane 62A.

A similar method of water jet peening comprising traversing the nozzle, and hence traversing the water jet, over the surface of a turbine vane segment 62 to produce a compressive residual stress into the surface of the turbine vane segment, metallic article, 62. But this method of water jet peening would not have an eighth pass as described above for a turbine blade 42 but instead would repeat the first, second and third passes A to C for each additional aerofoil 68 forming part of the turbine vane segment 62 and would have a ninth, tenth, eleventh and twelfth pass similar to the fourth, fifth, sixth and seventh passes described above performed on the other platform 64 or 66 of the turbine vane segment 62.

The method 100 may further comprise additional steps, before the first step 102, of casting the metallic article, machining apertures in the metallic article and grit blasting the surface of the metallic article.

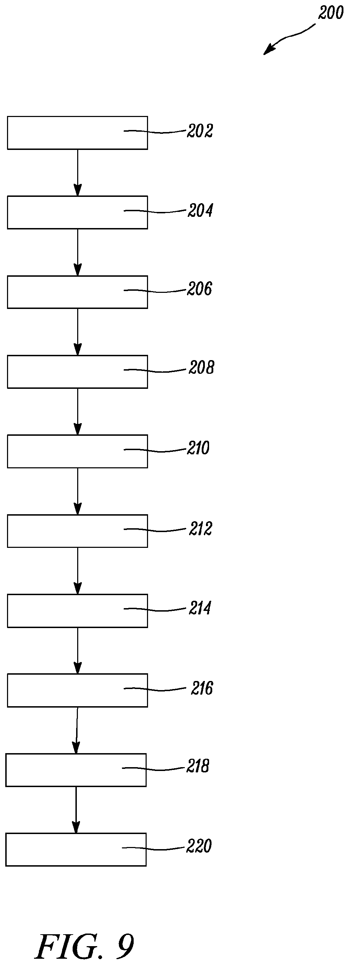

A further method of applying a ceramic coating onto a metallic article 200 is shown in figure 9. The metallic article 42, 62, 62A has a first portion and a second portion, the first portion having a metallic bond coating 82 and a ceramic coating 84 on the metallic bond coating 82 and the second portion having a metallic bond coating 86 and a ceramic coating 88 on the metallic bond coating 86. The ceramic coating 88 on the second portion is different to the ceramic coating 84 on the first portion. The metallic bond coating 86 on the second portion is different to the metallic bond coating 82 on the first portion. In this example the metallic bond coating 82 comprises a platinum-group metal enriched outer layer of the metallic article 42, 62, 62A and the metallic bond coating 86 comprises a platinum-group metal enriched outer layer of the metallic article 42, 62, 62A and an overlay coating on the platinum-group metal enriched outer layer of the metallic article 42, 62, 62A. In this example the ceramic coating 84 comprises a columnar grain ceramic coating and the ceramic coating 88 comprises a lamellae ceramic coating.

The method of applying a ceramic coating onto the metallic article 200 comprises a first step 202 of chemical cleaning of the metallic article 42, 62, 62A. The chemical cleaning comprises cleaning the surface of the metallic article 42, 62, 62A using a solvent and a detergent. The solvent dissolves contaminants, e.g. oil, grease, oxides, etc., from internal surfaces and external surfaces of the metallic article 42, 62, 62A. The detergent emulsifies and encapsulates contaminants and they are washed away.

A second step 204 of burning off, pyrolysis of, organic material from internal surfaces and external surfaces of the metallic article 42, 62, 62A. The burning off comprises placing the metallic article 42, 62, 62A in an oven and heating the metallic article 42, 62, 62A in a reduced oxygen atmosphere such that any organic material reacts and is broken down to a residue which is subsequently removed.

A third step 206 of water jet peening the metallic article 42, 62, 62A to produce a compressive residual stress in the metallic article 42, 62, 62A. The third step 206 of water jet peening also aids in removing alumina, the recast layer, from apertures in the metallic article 42, 62, 62A and/or removes alumina grit particles from the surface of the metallic article 42, 62, 62A. The third step 206 of water jet peening the metallic article 42, 62, 62A as mentioned above modifies the microstructure of the metallic article 42, 62, 62A to produce a compressive residual stress in the surface of the metallic article 42, 62, 62A and it is believed produces twinning, twin boundary cracks, of the microstructure which promotes enhanced inter-diffusion of the platinum-group metal in the surface of the metal article 42, 62, 62A.

The third step 206 comprises water jet peening the metallic article 42, 62, 62A by directing water at the metallic article 42, 62, 62A from a nozzle at a pressure of 275 to 296 MPa (40,000 to 43,000 psi), arranging the nozzle at a stand-off distance from the metallic article 42, 62, 62A of 20 to 30 mm and traversing the nozzle over the metallic article 42, 62, 62A at a speed of 2.5 to 3.8 mm per second. The water jet peening is arranged such that water droplets impact upon the metallic article. The third step 206 of water jet peening may comprise water jet peening the metallic article 42, 62, 62A by directing water at the metallic article 42, 62, 62A from a nozzle at a pressure of 275 to 290 MPa (40,000 to 42,000 psi), arranging the nozzle at a stand-off distance from the metallic article 42, 62, 62A of 22 to 28 mm and traversing the nozzle over the metallic article 42, 62, 62A at a speed of 2.7 to 3.5 mm per second. The third step 206 comprising directing water droplets with a diameter of 17 to 18 µm with a velocity of 650 ms⁻¹ to 690 ms⁻¹ onto the metallic article 42, 62, 62A. The third step 206 comprises directing water droplets onto the metallic article 42, 62, 62A to produce an impact pressure of equal to more than 10 GPa and equal to or less than 14 GPa. The third step 206 may comprise directing water droplets onto the metallic article 42, 62, 62A to produce an impact pressure of equal to more than 11 GPa and equal to or less than 13.5 GPa. The third step 206 comprises directing water droplets onto the metallic article 42, 62, 62A to produce a compressive residual stress to a depth of 60 µm from the surface of the metallic article of equal to or more than 1000 MPa and equal to or less than 1200 MPa.

In a first example the third step 206 comprises water jet peening the metallic article 42, 62, 62A by directing water at the metallic article 42, 62, 62A from a nozzle at a pressure of 284.7 MPa (41,300 psi), arranging the nozzle at a stand-off distance from the metallic article 42, 62, 62A of 25 mm and traversing the nozzle over the metallic article 42, 62, 62A at a speed of 2.9 mm per second. In this example the water jet peening is directed onto the surfaces of the aerofoil 50, 68 of the metallic article 42, 62, 62A. In the first example the third step 206 comprises directing water droplets onto the metallic article 42, 62, 62A to produce an impact pressure of equal to 13.0 GPa, e.g. the water jet peening is directed onto the surfaces of the aerofoil 50, 68 of the metallic article 42, 62, 62A. In the first example third step 206 comprises directing water droplets onto the metallic article 42, 62, 62A to produce a compressive residual stress of 1170 MPa to a depth of 60 µm from the surface of the metallic article, e.g. the water jet peening is directed onto the surfaces of the aerofoil 50, 68 of the metallic article 42, 62, 62A.

In a second example the third step 206 comprises water jet peening the metallic article 42, 62, 62A by directing water at the metallic article 42, 62, 62A from a nozzle at a pressure of 284.7 MPa (41,300 psi), arranging the nozzle at a stand-off distance from the metallic article 42, 62, 62A of 25 mm and traversing the nozzle over the metallic article 42, 62, 62A at a speed of 3.3 mm per second. In this example the water jet peening is directed onto the surface of the platforms 48, 66 of the metallic article 42, 62, 62A. In the second example the third step 206 comprises directing water droplets onto the metallic article 42, 62, 62A to produce an impact pressure of equal to 11.3 GPa, e.g. the water jet peening is directed onto the surface of the platforms 48, 66 of the metallic article 42, 62, 62A. In the second example the third step 206 comprises directing water droplets onto the metallic article 42, 62, 62A to produce a compressive residual stress of 1024 MPa to a depth of 60 µm from the surface of the metallic article, e.g. the water jet peening is directed onto the surface of the platforms 48, 66 of the metallic article 42, 62, 62A.

In the third step 206 the nozzle may be rotated around an axis, which axis, at 1000 rpm +/-100 rpm. In the third step 206 the nozzle has an orifice with a diameter of 0.58 mm. In the third step 206 the nozzle has a conical fan jet orifice. In the third step 206 the nozzle is mounted on a six axis robot to enable the nozzle to direct the water onto the metallic article 42, 62, 62A. The third step 206 may comprise water jet peening the metallic article as described with reference to Figures 8(a) to 8(e).

A fourth step 208 comprises depositing a bond coating onto the metallic article 42, 62, 62A. The fourth step 208 comprises applying a layer of platinum-group metal onto the metal article 42, 62, 62A. In this example a layer of platinum-group metal is applied onto the gas washed surfaces of the aerofoils 50, 68, 68A and the platforms 48, 64, 66, 64A, 66A of the metallic articles 42, 62, 62A. The layer of platinum-group metal, e.g. platinum, is applied onto the gas washed surfaces of the aerofoils 50, 68, 68A and the platforms 48, 64, 66, 64A, 66A of the metallic articles 42, 62, 62A by electroplating or other suitable method, e.g. sputtering, physical vapour deposition or chemical vapour deposition.

A fifth step 210 comprises heat treating the bond coating and metallic article 42, 62, 62A. The fifth step 210 comprises heat treating the metal article 42, 62, 62A to diffuse the platinum group metal, e.g. platinum, into the metallic article to form a platinum group metal enriched outer layer on the metal article 42, 62, 62A, e.g. an outer layer comprising platinum group metal enriched gamma prime phase in a platinum group metal enriched gamma phase matrix. The fifth step 210 comprises heating at a temperature of 1100 °C to 1200 °C, for example heating at a temperature of 1150 °C to 1200 °C.

A sixth step 212 comprises grit blasting the platinum group metal enriched outer layer on the metal article 42, 62, 62A or water jet blasting the platinum group metal enriched outer layer on the metal article 42, 62, 62A. The grit blasting may comprise using alumina grit, but this has a disadvantage of contaminating the surface of the platinum group metal enriched outer layer on the metal article 42, 62, 62A with alumina grit which may roughen the surface and affect the phase structure of the subsequently thermally grown oxide layer. The water jet blasting work hardens the platinum group metal enriched outer layer on the metal article 42, 62, 62A, promotes diffusion of alumina outwards to enhance the phase structure of the subsequently thermally grown oxide layer and smooths the surface. The water jet blasting comprises directing water at the platinum group metal enriched outer layer on the aerofoil 50, 68, 68A of the metallic article 42, 62, 62A from a nozzle at a pressure of 275 to 296 MPa (40,000 to 43,000 psi), arranging the nozzle at a stand-off distance from the metallic article 42, 62, 62A of 33 to 37mm and traversing the nozzle over the platinum group metal enriched outer layer on the metallic article 42, 62, 62A at a speed of 4.5 to 5.5 mm per second at an impact angle of 90°. The water jet blasting may comprise directing water at the platinum group metal enriched outer layer on the platform 48, 66, 66A of the metallic article 42, 62, 62A from a nozzle at a pressure of 275 to 290 MPa (40,000 to 42,000 psi), arranging the nozzle at a stand-off distance from the platinum group metal enriched outer layer on the metallic article 42, 62, 62A of 38 to 42 mm and traversing the nozzle over the platinum group metal enriched outer layer on the metallic article 42, 62, 62A at a speed of 6.2 to 7.2 mm per second at an impact angle of 90°.

A seventh step 214 comprises preheating the metal article 42, 62, 62A in an oxygen environment before applying the ceramic coating to thermally grow a thin metal oxide, e.g. alumina, layer on the platinum group metal enriched outer layer on the metal article 42, 62, 62A. The seventh step 214 comprises heating the metal article 42, 63, 62A to a temperature of at least 900 °C. The seventh step 214 may preheat the metal article 42, 63, 62A to a temperature of at least 1000 °C. It is preferred to preheat the metal article 42, 63, 62A to a temperature of at least 1100 °C, for example to a temperature in the range of 1150 °C to 1200 °C to form a stable alpha alumina phase layer on the platinum group metal enriched outer layer on the metal article 42, 62, 62A.

An eighth step 216 comprises depositing a layer of ceramic coating onto the thin metal oxide layer by physical vapour deposition to form a columnar grain ceramic coating. The columnar grain ceramic coating may be deposited by electron beam physical vapour deposition. A ninth step 218 comprises a stress relief heat treatment. The stress relief heat treatment comprises maintaining the ceramic coated metal article at a temperature of 1100 °C for one hour. A tenth step 220 comprises an age heat treatment. The age heat treatment comprises maintaining the ceramic coated metal article at a temperature of 870 °C for sixteen hours. The first, second, sixth, ninth and tenth steps are optional. The method 200 may further comprise additional steps, before the first step 202, of casting the metallic article, machining apertures in the metallic article and grit blasting the surface of the metallic article.

There may be an ultrasonic cleaning step, as described above, between the third and fourth steps.

Although the present disclosure has referred to the use of platinum group metal as the bond coating it is equally possible to use an overlay coating, a diffusion aluminide coating, a platinum group metal and an overlay coating, e.g. an overlay coating on a platinum group metal or a platinum group metal on an overlay coating, or a diffusion aluminide coating and an overlay coating, e.g. an overlay coating on an aluminide coating or an aluminide coating on an overlay coating. The diffusion aluminide coating may be deposited by chemical vapour deposition, pack aluminising, out of pack aluminising or slurry aluminising. The overlay coating may be deposited by thermal spraying, e.g. air plasma spraying, vacuum plasma spraying, high-velocity oxy-fuel spraying etc. The metallic article is generally heat treated after deposition of the bond coating and before deposition of the ceramic coating.

The method according to the present disclosure uses caustic leaching to aid removal of a recast layer, an oxide and/or alumina layer, from the machined surfaces, e.g. film cooling apertures, and aid removal of alumina grit particles from the surface of, the metallic article. The rinsing in water at ambient temperature also aids removal of recast layer, an oxide and/or alumina layer, from the machined surfaces, e.g. film cooling apertures, and aid removal of alumina grit particles from the surface of, the metallic article by creating a thermal shock. The ultrasonic cleaning process also aids removal of recast layer, an oxide and/or alumina layer, from the machined surfaces, e.g. film cooling apertures, and aid removal of alumina grit particles from the surface of, the metallic article. The removal of oxide and/or alumina layer and/or the alumina grit particles promotes enhanced inter-diffusion of the platinum-group metal in the surface of the metal article. The water jet peening modifies the microstructure of the metallic article to produce a compressive residual stress in the surface of the metallic article and produces twinning, twin boundary cracks, of the microstructure which promotes enhanced inter-diffusion of the platinum-group metal in the surface of the metal article, especially in the absence of the recast later and the alumina grit particles. The improved inter-diffusion of the platinum-group metal produces a more homogeneous platinum-group metal enriched outer layer on the metal article to provide enhanced oxidation and corrosion resistance. The water jet peening also aids removal of the recast layer, the oxide and/or alumina layer, from the machined surfaces, e.g. film cooling apertures, and aids removal of alumina grit particles from the surface of the metallic article. The water jet peening also improves the surface finish of the metallic article. The omission of grit blasting prior to platinum-group metal plating prevents alumina grit entrapment by the platinum-group metal. A higher heat treatment temperature prior to deposition of the ceramic coating, followed by a stress relieving heat treatment of the ceramic coating after the deposition of the ceramic coating improves the overall durability of the thermal barrier coating in service. The method according to the present disclosure enables an increase in the operating life of the thermal barrier coating or enables a reduction in the thickness of the platinum-group metal layer deposited onto the metallic article to reduce the cost of the thermal barrier coating while maintaining the operating life of the thermal barrier coating.

It will be understood that the invention is not limited to the embodiments above-described and various modifications and improvements can be made without departing from the concepts described herein within the scope of the following claims.

## Claims

1. A method (100) of applying a ceramic coating onto a metallic article (42, 62, 62A), the method comprising the sequential steps of:
a) producing a compressive residual stress (122) in the surface of the metallic article (42, 62, 62A) by water jet peening the metallic article;
b) applying a bond coating (126) to the surface of the metallic article by the sequential steps of:
i) applying a layer of platinum-group metal onto the metal article,
ii) heat treating the metallic article to diffuse the platinum-group metal into the metallic article to produce a platinum-group metal enriched outer layer on the metallic article, and
iii) heating the metallic article in an oxygen containing atmosphere to form a layer of alpha alumina on the surface of the platinum-group metal enriched outer layer of the metallic article; and
c) depositing the ceramic coating (134) onto the layer of alpha alumina on the metallic article (42, 62, 62A).

2. The method of claim 1, further comprising a step after heat treating the metallic article (42, 62, 62A)to diffuse the platinum-group metal into the metallic article to produce a platinum-group metal enriched outer layer on the metallic article and before forming the layer of alpha alumina on the surface of the platinum-group metal enriched outer layer of the metallic article of grit blasting or water jet blasting the surface of the platinum-group metal enriched outer layer of the metallic article.

3. The method of claim 1 or 2, wherein the layer of platinum-group metal is applied to the metallic article (42, 62, 62A) without alumina grit blasting the metallic article before applying the layer of platinum-group metal so that no alumina grit is left trapped on the surface of the metal article.

4. The method of any one of claims 1 to 3, further comprising a step of chemical cleaning before step a), the chemical cleaning comprises using a solvent and a detergent.

5. The method of claim 4, further comprising a step of removing organic material from the metallic article (42, 62, 62A) after chemical cleaning and before step a), the removing of the organic material comprises heating the metallic article to burn the organic material.

6. The method of any one of claims 1 to 5, wherein step a) comprises water jet peening the metallic article (42, 62, 62A) by directing water at the metallic article from a nozzle at a pressure of 40,000 to 43,000 psi (275 to 296 MPa), arranging the nozzle at a stand-off distance from the metallic article of 20 to 30 mm and traversing the nozzle over the metallic article at a speed of 2.5 to 3.8 mm per second.

7. The method of any one of claims 1 to 6, wherein step a) comprises water jet peening the metallic article (42, 62, 62A) by directing water at the metallic article from a nozzle at a pressure of 40,000 to 42,000 psi (275 to 290 MPa), arranging the nozzle at a stand-off distance from the metallic article of 22 to 28 mm and traversing the nozzle over the metallic article at a speed of 2.7 to 3.5 mm per second.

8. The method of any one of claims 1 to 7, wherein step a) comprises water jet peening the metallic article (42, 62, 62A) by directing water at the metallic article from a nozzle at a pressure of 41,300 psi (284.7 MPa), arranging the nozzle at a stand-off distance from the metallic article of 25 mm and traversing the nozzle over the metallic article at a speed of 2.9 mm per second.

9. The method of any one of claims 1 to 7, wherein step a) comprises water jet peening the metallic article (42, 62, 62A) by directing water at the metallic article from a nozzle at a pressure of 41,300 psi (284.7 MPa), arranging the nozzle at a stand-off distance from the metallic article of 25 mm and traversing the nozzle over the metallic article at a speed of 3.3 mm per second.

10. The method of any one of claims 1 to 8, further comprising a step of ultrasonic cleaning after step a) and before step b), the ultrasonic cleaning step comprises immersing the metallic article (42, 62, 62A) in a weak acid and agitating the weak acid using ultrasonic signals to generate cavitation in the weak acid.

11. The method of any one of claims 1 to 3, wherein step iii) comprises heating at a temperature of 1150 °C to 1200 °C.

12. The method of any one of claims 1 to 11, wherein step a) comprises directing water droplets onto the metallic article (42, 62, 62A) to produce an impact pressure of equal to more than 10 GPa and equal to or less than 14 GPa.

13. The method of any one of claims 1 to 12, wherein step a) comprises directing water droplets onto the metallic article (42, 62, 62A) to produce an impact pressure of equal to more than 11 GPa and equal to or less than 13.5 GPa.

14. The method of any one of claims 1 to 13, wherein step a) comprises directing water droplets onto the metallic article (42, 62, 62A) to produce an impact pressure of equal to 11.3 GPa or directing water droplets onto the metallic article to produce an impact pressure of equal to 13.0 GPa.

15. The method of any one of claims 1 to 14, wherein step a) comprises producing a compressive residual stress (122) to a depth of 60 µm from the surface of the metallic article (42, 62, 62A) of equal to or more than 1000 MPa and equal to or less than 1200 MPa.
